(19) **Europäisches Patentamt**

**European Patent Office**

**Office européen des brevets**

(11) **EP 0 833 130 B1**

(12) **EUROPÄISCHE PATENTSCHRIFT**

(45) Veröffentlichungstag und Bekanntmachung des Hinweises auf die Patenterteilung:
**26.11.2003 Patentblatt 2003/48**

(51) Int Cl.⁷: **G01D 5/244**, G01D 5/245, H03M 1/30

(21) Anmeldenummer: **97115393.7**

(22) Anmeldetag: **05.09.1997**

(54) **Positionsmesssystem und Messverfahren**

Position measuring system and method

Système et procédé de mesure de position

(84) Benannte Vertragsstaaten:
**AT CH DE FR GB IT LI**

(30) Priorität: **25.09.1996 DE 19639316**

(43) Veröffentlichungstag der Anmeldung:
**01.04.1998 Patentblatt 1998/14**

(73) Patentinhaber: **Dr. Johannes Heidenhain GmbH
83292 Traunreut (DE)**

(72) Erfinder:
- **Bielski, Steffen, Dipl.-Ing.(FH)
  84518 Garching (DE)**
- **Huber, Helmut, Dipl.-Ing. (FH)
  84518 Garching/Wald (DE)**
- **Hofbauer, Hermann, Dipl.-Ing. (FH)
  83308 Trostberg (DE)**

(56) Entgegenhaltungen:
**EP-A- 0 455 984**            **WO-A-89/11080**
**DE-A- 4 217 498**           **DE-C- 19 513 692**

**Beschreibung**

Die Erfindung betrifft ein Positionsmeßsystem und ein Meßverfahren zum Ermitteln einer absoluten Position.

Bei einer Vielzahl von Elektromotoren ist es erforderlich, bei Inbetriebnahme die absolute Lage des Rotors zu kennen, damit beim Einschalten die Stromdurchflutung der Wicklungen im richtigen Winkel zur Drehachse liegt und somit der Rotor in der gewünschten Drehrichtung mit dem gewünschten Drehmoment anläuft. Der Winkelbereich, innerhalb dessen die Absolutposition bekannt sein muß, ist abhängig vom Aufbau des Elektromotors. Um ein Winkelmeßsystem flexibel einsetzen zu können, ist es üblich, die Absolutposition zur Kommutierung eines Elektromotors über eine volle Umdrehung eindeutig zu bestimmen. Im nachfolgenden Betrieb soll das Winkelmeßsystem die Lage des Rotors möglichst hochgenau ausgeben.

Aus der WO 89/11080 ist ein Positionsmeßsystem mit zwei Teilungsspuren bekannt, dessen Teilungsperioden sich nur geringfügig unterscheiden. Aus der Phasendifferenz der Abtastsignale werden Signale gewonnen, die zur Kommutierung eines Elektromotors dienen.

Aus der DE 195 13 692 C1 ist ein weiteres Positionsmeßsystem in Form eines Winkelmeßsystems bekannt, das Signale zur Kommutierung ausgibt. Auf einem Teilungsträger ist eine erste Spur vorgesehen, die ein Sinus-Cosinus-Signalpaar mit einer einzigen Periode pro Umdrehung liefert und eine zweite Spur vorgesehen, die ein Sinus-Cosinus-Signalpaar mit einer sehr hahen Anzahl von Perioden pro Umdrehung liefert. Bei Inbetriebnahme eines Elektromotors werden die Signale der ersten Spur einer Auswerteeinheit zugeführt. Nach erfolgter Kommutierung erfolgt eine Umschaltung, so daß der Auswerteeinheit Sinus-Cosinus-Signalpaare der zweiten Spur mit einer sehr hohen Anzahl von Perioden pro Umdrehung zugeführt werden. Eine Korrektur des damit gemessenen Winkels erfolgt durch ein Synchronisationssignal einer Referenzmarke.

Ein Nachteil dieses Positionsmeßsystems besteht darin, daß eine Fehlfunktion des Umschalters zu einer erheblichen Fehlpositionierung führt. Erfolgt keine korrekte Umschaltung von den grobauflösenden Signalen der ersten Spur auf die feinauflösenden Signale der zweiten Spur, führt dies dazu, daß ein nachgeordneter Drehzahl- bzw. Lageregler mit einem sehr hohen Faktor hochdreht bzw. falsch positioniert.

Der Erfindung liegt die Aufgabe zugrunde, ein Positionsmeßsystem und ein Meßverfahren anzugeben, bei dem eine derart große Fehlpositionierung vermieden wird.

Diese Aufgabe wird mit einem Positionsmeßsystem mit den Merkmalen des Anspruches 1 und mit einem Positionsmeßverfahren mit den Merkmalen des Anspruches 4 gelöst.

Vorteilhafte Ausbildungen sind in den abhängigen Ansprüchen angegeben.

Die Vorteile des erfindungsgemäßen Positionsmeßsystems und Meßverfahrens bestehen darin, daß auch bei einer Fehlfunktion des Umschalters nur eine geringe Fehlpositionierung erfolgen kann, was auch den Einsatz bei besonders sicherheitsrelevanten Einrichtungen und Verfahren ermöglicht.

Mit Hilfe von Ausführungsbeispielen wird die Erfindung anhand der Zeichnungen näher erläutert.

Es zeigt

Figur 1  schematisch ein Winkelmeßsystem,

Figur 2  die Abtastsignale des Winkelmeßsystems nach Figur 1,

Figur 3  ein weiteres Winkelmeßsystem und

Figur 4  ein Signaldiagramm.

Das erfindungsgemäße Winkelmeßsystem besteht aus einem Drehgeber 1 und einer Auswerteeinheit 2. Die Welle 3 des Drehgebers 1 ist mit einer Welle eines Elektromotors 4 gekoppelt. Die Drehung der Welle 3 wird durch Abtastung einer Teilscheibe 5 mittels einer Abtasteinheit 6 gemessen. Die analogen Abtastsignale A1 bis A4 und RS werden der Auswerteeinheit 2 zugeführt. Die Auswerteeinheit 2 verarbeitet die Abtastsignale A1 bis A4 und RS derart, daß insbesondere bei Inbetriebnahme des Motors 4 und somit bei Stillstand der Welle 3 eine zur Kommutierung erforderliche absolute Position K ausgegeben werden kann und bei späterem Betrieb eine hochgenaue Positionserfassung zur Steuerung einer Maschine bzw. eines Prozesses mittels einer Steuerung 7 ermöglicht wird.

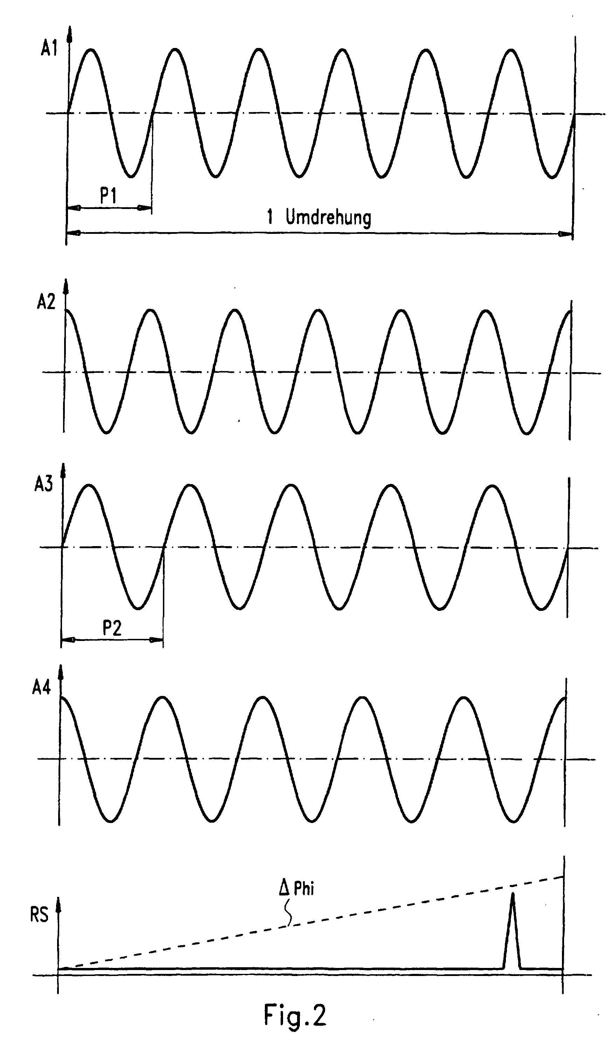

Hierzu ist auf der Teilscheibe 5 eine erste periodische Teilungsspur 8 und eine parallel dazu verlaufende zweite periodische Teilungsspur 9 vorgesehen. Jede dieser Teilungsspuren 8 und 9 besitzt über eine Umdrehung eine Vielzahl von Teilungsperioden P1, P2. Die Teilungsperiode P1 der ersten Teilungsspur 8 unterscheidet sich nur geringfügig von der Teilungsperiode P2 der zweiten Teilungsspur 9. Im Idealfall weist die erste periodische Teilungsspur 8 N Teilungsperioden P1 und die zweite Teilungsspur 9 (N-1) Teilungsperioden P2 pro Umdrehung auf. Die bei der Abtastung der ersten Teilungsspur 8 entstehenden analogen Abtastsignale A1, A2 sowie bei der Abtastung der zweiten Teilungsspur 9 entstehenden analogen Abtastsignale A3, A4 sind in Figur 2 schematisch dargestellt. Daraus ist ersichtlich, daß aus jeder Teilungsspur 8, 9 jeweils zwei um 90° gegeneinander phasenverschobene sinusförmige Abtastsignale A1, A2 bzw. A3, A4 gewonnen werden.

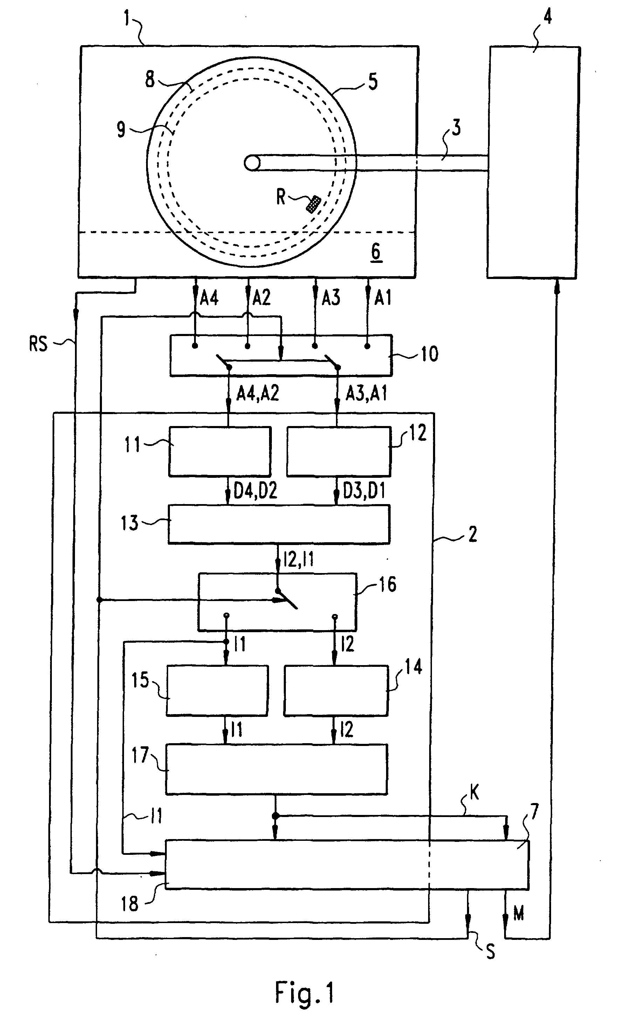

Bei Inbetriebnahme des Motors 4, das heißt bei der ersten Bestromung des Motors 4 nach Abschalten oder Stromunterbrechung muß die momentane absolute Lage der Welle 3 bekannt sein, damit die Steuerung 7 den Motor 4 zur Kommutierung korrekt bestromen kann. Bei Inbetriebnahme wird hierzu von der Steuerung 7 ein Steuersignal S an eine Umschalteinrichtung 10 gegeben und veranlaßt, daß zuerst die Abtastsignale A3, A4 und danach die Abtastsignale A1 und A2 der Auswerteeinheit 2 zugeführt werden. Die Figur 1 zeigt die erste Schalterstellung der Umschalteinrichtung 10, in der die beiden um 90° gegeneinander phasenverschobenen Abtastsignale A3 und A4 den nachfolgenden Analog-Digital-Wandlern 11, 12 zugeführt werden. In bekannter Weise dienen die so erzeugten Digitalwerte D3 und D4 als Adressen einer nachgeschalteten Interpolationstabelle 13, so daß am Ausgang die momentane Absolutposition I2 innerhalb einer Teilunsperiode P2 ansteht. Diese Absolutposition 12 kann somit anhand der momentanen Signalamplitudenwerte der analogen Abtastsignale A3, A4 mit sehr hoher Auflösung und Genauigkeit ermittelt werden. Die Absolutposition I2 wird in einen Speicher 14 abgelegt.

Nach diesem ersten Interpolationsprozeß veranlaßt die Steuerung 7 durch das Steuersignal S eine Umschaltung der Umschalteinrichtung 10, so daß die beiden Abtastsignale A1 und A2 den A/D-Wandlern 11 und 12 zugeführt werden. Aus den Digitalwerten D1, D2 wird in der Interpolationstabelle 13 ein Wert bestimmt, der die momentane Absolutposition 11 innerhalb einer Teilunsperiode P1 angibt. Diese Absolutposition I1 wird einem weiteren Speicher 15 zugeführt und abgespeichert. Um diesen Ablauf in Figur 1 verständlich darzustellen, ist hierzu eine weitere Umschalteinrichtung 16 vorgesehen, die vom Steuersignal S angesteuert wird. Anstatt der Interpolationstabelle 13 können auch andere, an sich bekannte Interpolationseinrichtungen Verwendung finden.

Wie bereits erwähnt, unterscheiden sich die Perioden P1 und P2 geringfügig. Die Differenz (P2-P1) ist so gewählt, daß aus der Phasendifferenz der Abtastsignale A1, A2 und A3, A4 die Absolutposition K innerhalb einer Umdrehung eindeutig ermittelt werden kann. Der Verlauf dieser Phasendifferenz ∆Phi ist in unteren Diagramm in Figur 2 schematisch eingezeichnet. Dieser Verlauf der Phasendifferenz ∆Phi kann besonders einfach durch Vergleich der Interpolationswerte I1 und I2 nachgebildet werden. Hierzu werden die Interpolationswerte I1 und I2 einem Vergleicher 17 zugeführt, an dessen Ausgang die absolute Position K abgenommen werden kann. Die Auflösung dieser absoluten Position K sowie die Genauigkeit mit der diese absolute Position K ermittelt werden muß, ist abhängig vom zu kommutierenden Motor 4. Es muß eine zur Kommutierung ausreichende Auflösung und Genauigkeit gewährleistet sein.

Diese absolute Position K wird der Steuerung 7 zugeführt, die daraufhin dem Motor 4 die korrekten Motorströme M zum Anlauf zuführt. Bei dieser beginnenden Betriebsphase wird die Verdrehung der Teilscheibe 5 durch Auswertung des Interpolationswertes I1 weiter erfaßt, indem diese Werte I1 in an sich bekannter Weise einem Zähler 18 zugeführt werden. Diese Positionserfassung mittels des Zählers 18 wird auch als inkremetales Meßverfahren bezeichnet. Die nun während des Betriebes vom Zähler 18 erfaßten Positionsmeßwerte werden der Steuerung 7 zugeführt die daraufhin in bekannter Weise über einen Lageregler und Geschwindigkeitsregler dem Motor 4 den passenden Strom M zuführt.

Es besteht die Möglichkeit, vor Beginn der inkrementalen Messung den Zählerstand des Zähler 18 auf den absoluten Positionswert K zu setzen. Eine exakte Synchronisierung des Zählers 18 erfolgt beim Abtasten einer Referenzmarke R durch das in Figur 2 dargestellte Referenzmarkensignal RS. Da die absolute Position der Referenzmarke R bekannt ist, steht' nach dem erstmaligen Passieren dieser Referenzmarke R in Verbindung mit den inkrementalen Meßwerten I1 ein hochgenauer, absoluter Positionsmeßwert im Zähler 18 zur Verfügung. Die Referenzmarke R besteht in an sich bekannter Weise aus einer Kombination von Teilstrichen, die sich über mehrere Teilungsperioden P1 der Inkrementalteilung 8 erstreckt. Bei der Abtastung einer derartigen Referenzmarke R entsteht das Referenzmarkensignal RS, das getriggert einen Impuls ergibt, der zumindest einer bestimmten Teiiungsperiode der Spur 8 eindeutig zugeordnet ist. Die dieser Periode zugeordnete Absolutposition ist in einem Speicher abgespeichert und wird bei Auftreten des Impulses dem Zähler 18 als Zählerstand zugeführt. Bei Optimierung der Referenzmarke R ist es sogar möglich, mit dem Impuls einem Bruchteil einer Teilungsperiode eine absolute Position eindeutig zuzuordnen. Im gezeigten Beispiel ist nur eine einzige Referenzmarke R pro Umdrehung dargestellt.

Es können auch mehrere, über den Umfang gleichmäßig oder ungleichmäßig beabstandete Referenzmarken vorgesehen sein.

Das Vorsehen von Referenzmarken in ungleichen Abständen hat den Vorteil, daß während des Betriebes durch Zählen der Inkremente zwischen jeweils zwei Referenzmarken die Absolutposition hochgenau erfaßt werden kann. Das Auswerteverfahren hierzu ist an sich bekannt, wozu ausdrücklich auf die DE 24 16 212 A verwiesen wird. Bei mehreren gleichbeabstandeten Referenzmarken innerhalb einer Umdrehung der Teilscheibe 5 ist die Absolutposition für jede Referenzmarke in einem Speicher abgelegt. Um beim Abtasten einer der Referenzmarken den korrekten Speicherinhalt auszulesen, können den Referenzmarken unterschiedliche Codierungsmerkmale zugeordnet sein. Eine besonders vorteilhafte Codierung ist bei dem erfindungsgemäßen Positionsmeßsystem durch die grobauflösende Absolutposition K gegeben. Sind beispielsweise drei Referenzmarken vorgesehen, eine erste bei 0°, eine zweite bei 120° und ein dritte bei 240°, und kann die absolute Position K mit einer Genauigkeit von ±10° angegeben werden, dann ist eindeutig bestimmbar, daß die erste Referenzmarke innerhalb des ersten Bereiches 350° bis 10°, die zweite Referenzmarke innerhalb des zweiten Bereiches 110° bis 130° und die dritte Referenzmarke innerhalb des dritten Bereiches 230° bis 250° liegen muß. Wird eine der drei Referenzmarken abgetastet, und ist z.B. K=7°, kann der Zähler auf die der ersten Referenzmarke eindeutig zugeordneten Absolutposition 0° gesetzt werden und zwar mit der Genauigkeit der Referenzmarkenlage.

Vergleicht man das Winkelmeßsystem gemäß Figur 1 mit der in der DE 195 13 692 C1 beschriebenen Einrichtung, so wird deutlich, daß nur bei dem erfindungsgemäßen Winkelmeßsystem gewährleistet ist, daß bei einer falschen Schalterstellung des Umschalters 10 nur eine geringe Fehlpositionierung erfolgen kann. Ein besonderer Vorteil unserer Erfindung besteht darin, daß die zur erstmaligen Kommutierung erforderliche grobauflösende absolute Positonsmessung sowie die nachfolgende inkrementale feinauflösende und hochgenaue Positionsmessung mit den gleichen Komponenten 11, 12, 13 realisiert werden kann.

Um eine falsche Schaltereinstellung beim inkrementalen Meßverfahren während des Betriebes zu detektieren, kann eine Überwachungsvorrichtung vorgesehen sein, welche die Anzahl der Inkremente bzw. Perioden die dem Zähler 18 zwischen zwei Referenzmarkensignalen RS zugeführt werden erfaßt und mit vorgegebenen Sollwerten vergleicht. Weicht die Anzahl der erfaßten Inkremente von dem Sollwert um einen vorgegebenen Toleranzwert (optimal = 0) ab, kann die Umschalteinrichtung 10 richtig umgestellt werden und/oder ein Fehler- bzw. Warnsignal abgegeben werden.

Trotz einer eventuell falschen Schalterstellung ist maximal eine Fehlpositionierung einer Periodenlänge P1 innerhalb einer vollen Umdrehung möglich. Da zur inkrementalen Messung die Periodenlänge P1 möglichst klein sein soll, sind in der Regel einige Hundert Perioden P1 innerhalb einer Umdrehung vorhanden, so daß die maximal mögliche Fehlpositionierung sehr klein ist. In der Praxis ist beispielsweise P1=360°/2048 und P2=360°/2047.

Im dargestellten Beispiel erfolgt die Interpolation mittels einer Tabelle 13, die Interpolation kann aber auch mittels eines Rechners ($\mu$P) erfolgen. Die gesamte Auswertung kann in einen Mikroprozessor ($\mu$P) in Form von Ablaufroutinen durchgeführt werden.

Die analogen Abtastsignale A1 bis A4 und RS können durch lichtelektrische, kapazitive, magnetische oder induktive Abtastprinzipien gewonnen werden.

Die Umschalteinrichtung 10 kann Bestandteil der Auswerteeinheit 2 oder des Drehgebers 1 sein. Durch die Integration in den Drehgeber 1 können Übertragungsleitungen zur Auswerteeinheit 2 gespart werden, was besonders vorteilhaft ist, wenn die Auswerteeinheit 2 der Steuerung 7 zugeordnet oder in der Steuerung 7 integriert ist. Es ist auch möglich, die Umschalteinrichtung 10 und die Auswerteeinheit 2 in den Drehgeber 1 zu integrieren.

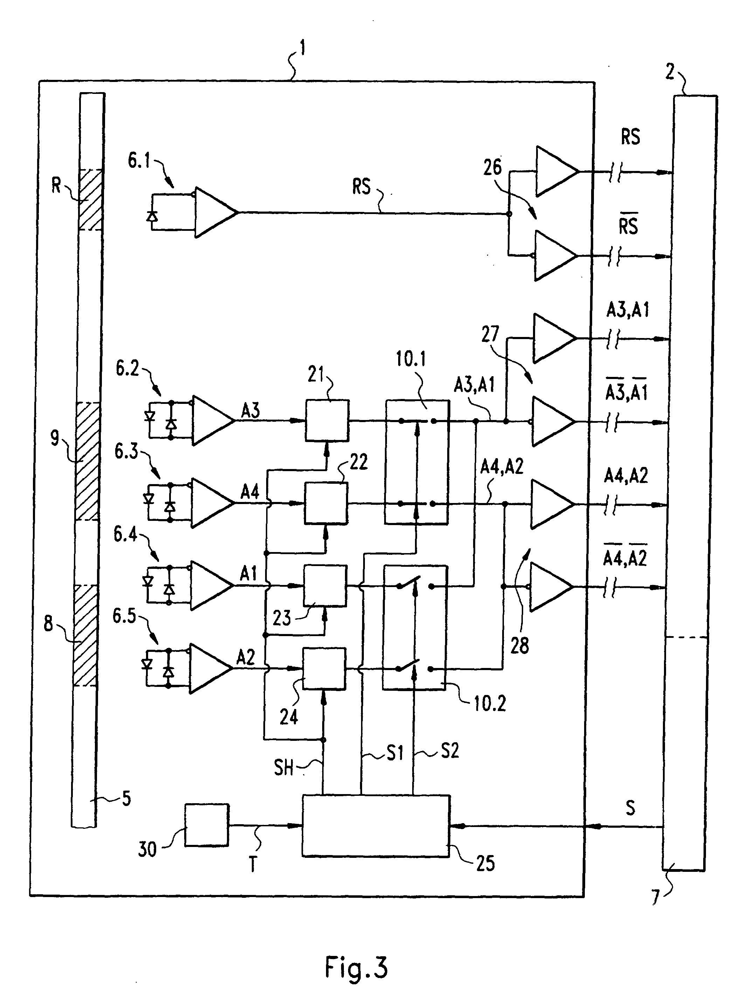

Um die Momentanwerte der Abtastsignale A1 bis A4 zum gleichen Zeitpunkt ablesen zu können, ist es weiterhin möglich, daß vor der Schalteinrichtung 10 Speicher zur gleichzeitigen Übernahme aller Momentanwerte der Abtastsignale A1 bis A4 angeordnet sind. Ein Beispiel hierzu ist in Figur 3 dargestellt. Bei dieser Ausführung ist die Umschalteinrichtung 10 im Drehgeber 1 selbst untergebracht. Die schematisch dargestellte Teilscheibe 5 wird von den Abtastelementen 6.1 bis 6.5 zur Erzeugung der analogen Abtastsignale A1 bis A4 und RS abgetastet. Jedes der Abtastsignale A1 bis A4 wird einem eigenen Speicher 21, 22, 23, 24 zur Zwischenspeicherung zugeführt. Wird von der Steuerung 7 das Steuersignal S zum Drehgeber 1 geführt, veranlaßt die Logik 25 die gleichzeitige Übernahme aller Momentanwerte der Abtastsignale A1 bis A4 in die Speicher 21 bis 24. Gleichzeitig wird der Umschalteinrichtung 10.1 ein Steuersignal S1 zugeführt, welches veranlaßt, die Abtastsignale A3, A4 auszugeben. Die Logik 25 veranlaßt danach eine Umschaltung der Umschalteinrichtungen 10.1 und 10.2 aufgrund eines weiteren Steuersignales S2, so daß nur die Abtastsignale A1 und A2 ausgegeben werden. In dieser ersten Betriebsart werden somit die Abtastsignale A3, A4 und danach die Abtastsignale A1, A2 auf gemeinsamen Leitungen sequentiell zu einer entfernt angeordneten Auswerteeinheit 2 geleitet, um die absolute Position K zu ermitteln. Die Logik 25 schaltet nach diesem Vorgang die Umschalteinrichtungen 10.1 und 10.2 wieder in die Ausgangsstellung zurück, um in der zweiten Betriebsart zur inkrementalen Positionsmessung kontinuierlich die Abtastsignale A3, A4 an die Auswerteeinheit 2 zu leiten. In Figur 3 sind am Ausgang des Drehgebers 1 sogenannte Treiberbausteine 26 bis 28 für jede Ausgangsleitung vorgesehen. Diese Treiberbausteine 26 bis 28 sind in der Lage, für jedes Abtastsignal A1 bis A4 und RS auch ein gegenphasiges Abtastsignal $\overline{A1}$ bis $\overline{A4}$ und $\overline{RS}$ auszugeben.

Die Inbetriebnahme des Motors 4 wird dem Drehgeber 1 bzw. der Auswerteeinheit 2 bei den bisher beschriebenen Ausführungsbeispielen durch das Steuersignal S mitgeteilt. Es ist auch möglich, daß die Auswerteeinheit 2 bzw. der Drehgeber 1 selbst die anstehende Versorgungsspannung überwacht und somit die Inbetriebnahme erkennt und die Steuersignale S bzw. S1, S2 davon abhängig erzeugt, und die korrekte Umschaltung auf die beiden Betriebsarten veranlaßt.

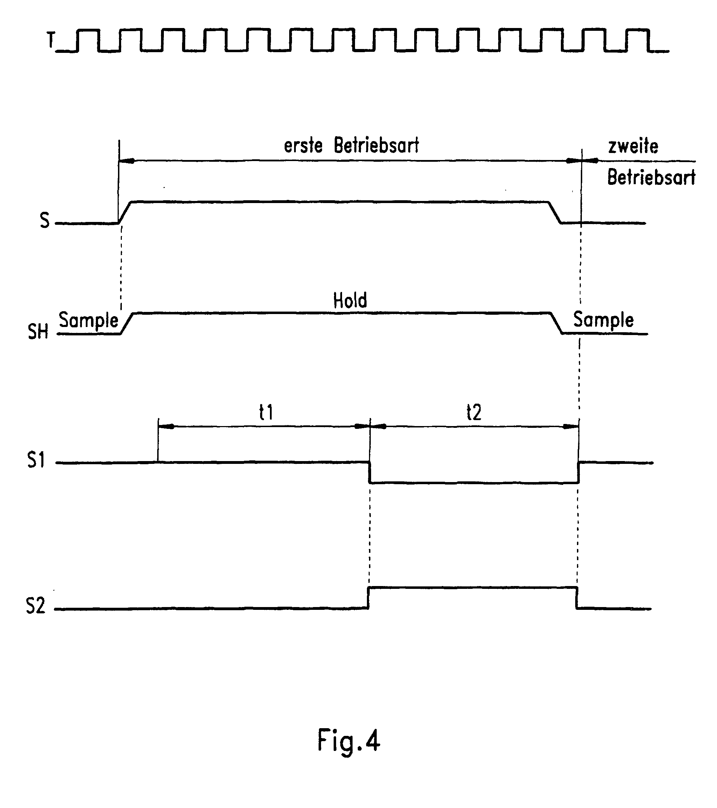

In Figur 4 ist die von der Logik 25 zeitlich gesteuerte Umschaltung dargestellt. An dem Eingang der Logik 25 stehen die Signale T eines Taktgebers 30 an. Aufgrund des anstehenden Steuersignales S wird die erste Betriebsart eingeleitet, das heißt, daß die Momentanwerte der Abtastsignale A1 bis A4 in den Speichern 21 bis 24 abgespeichert werden, diese Speicherroutine ist mit SH (Sample & Hold) bezeichnet. Innerhalb der Zeit t1 werden die Abtastsignale A3, A4 zur nachfolgenden Auswerteeinheit 2 weitergeleitet und nach einer vorgegebenen Anzahl von Taktzyklen erfolgt eine Umschaltung zum Weiterleiten der Abtastsignale A1, A2. Nach einer weiteren vorgegebenen Anzahl von Taktzyklen t2 erfolgt eine weitere Umschaltung der Umschalteinrichtung 10 bzw. 10.1 und 10.2 zur kontinuierlichen Weitergabe der Abtastsignale A3, A4 und somit eine Umschaltung auf die zweite Betriebsart.

Im gezeigten Beispiel wird die absolute Winkelposition K durch eine Interpolationstabelle 13 und einem Rechenschritt im Vergleicher 17 ermittelt. In nicht dargestellter Weise ist es auch möglich, einen Baustein vorzusehen, an dessen Eingänge die Abtastsignale A1, A2, A3, A4 sowie das Steuersignal S anstehen und an dessen Ausgang in der ersten Betriebsart die Absolutposition K und in der zweiten Betriebsart ein inkrementaler Wert I1 oder I2 ansteht.

**Patentansprüche**

1.  Positionsmeßsystem mit einem Teilungsträger (5), der mehrere periodische Teilungsspuren (8, 9) unterschiedlicher Teilungsperioden aufweist, einer Abtasteinheit (6) zur Erzeugung von analogen Abtastsignalen (A1 bis A4) einer ersten und einer zweiten Periode (P1, P2), wobei sich die Perioden (P1, P2) der ersten und zweiten Abtastsignale (A1 bis A4) nur geringfügig voneinander unterscheiden, mit einer Umschalteinrichtung (10, 16), welche ansteuerbar ist, um

    a) einer Auswerteeinheit (2) in einer ersten Betriebsart gleichzeitig oder sequentiell die Abtastsignale (A1 bis A4) beider Perioden (P1, P2) zuzuführen, um in einem Baustein (17) aus den Momentanwerten (I1, I2) der Abtastsignale (A1 bis A4) beider Perioden (P1, P2) eine absolute Position (K) zu bilden und auszugeben, und um
    b) der Auswerteeinheit (2) in einer zweiten Betriebsart zumindest ein Abtastsignal (A1 bis A4, D1 bis D4) einer der beiden Perioden (P1, P2) zuzuführen, um aus den Momentanwerten (I1) der Abtastsignale (A1 bis A4, D1 bis D4) nur einer der beiden Perioden (P1, P2) eine inkrementale Positionsmessung durchzuführen und einen hochauflösenden Positionsmeßwert auszugeben.

2.  Positionsmeßsystem nach Anspruch 1, **dadurch gekennzeichnet, daß** auf dem Teilungsträger (5) zumindest eine Referenzmarke (R) mit bekannter Absolutposition vorgesehen ist, und daß weiterhin eine Interpolationseinrichtung (13) vorgesehen ist, an dem in der zweiten Betriebsart eines der Abtastsignale (A1 bis A4, D1 bis D4) kontinuierlich ansteht und der darin gebildete Interpolationswert (I1) einem Zähler (18) zugeführt wird, wobei an dem Zähler (18) bei der Abtastung der Referenzmarke (R) ein Synchronisationssignal (RS) ansteht.

3.  Positionsmeßsystem nach Anspruch 1 oder 2, **dadurch gekennzeichnet, daß** der Teilungsträger eine Teilscheibe (5) eines Drehgebers (1) ist, und daß die erste Teilungsspur (8) N Teilungsperioden (P1) und die zweite Teilungsspur (9) N-1 Teilungsperioden pro Umdrehung aufweist.

4.  Positionsmeßverfahren zum Ermitteln der absoluten Position eines beweglichen Teiles (3), mit einem Teilungsträger (5), der mehrere periodische Teilungsspuren (8, 9) mit geringfügig unterschiedlichen Teilungsperioden (P1, P2) aufweist, die von einer Abtasteinheit (6) zur Erzeugung von Abtastsignalen (A1 bis A4) einer ersten und einer zweiten Periode (P1, P2) abgetastet werden, wobei in einer ersten Betriebsart einer Auswerteeinheit (2) die Abtastsignale (A1 bis A4) der ersten Periode (P1) und der zweiten Periode (P2) zugeführt werden und aus der Phasendifferenz ($\Delta$Phi) dieser Abtastsignale (A1 bis A4) eine grobauflösende Absolutposition (K) bestimmt und ausgegeben wird, und in einer nachfolgenden zweiten Betriebsart eines der beiden Abtastsignale (A1, A2; A3, A4) erster oder zweiter Periode (P1; P2) in einer Interpolationseinrichtung (13) zur inkrementalen Positionsmessung unterteilt und ein hochauflösender Positionsmeßwert (I1) ausgegeben wird.

5.  Positionsmeßverfahren nach Anspruch 4, **dadurch gekennzeichnet, daß** die in der ersten Betriebsart ermittelte grobauflösende Absolutposition (K) einer Steuerung (7) zugeführt wird, die davon abhängig den Anlauf eines Elektromotors (4) steuert.

6.  Positionsmeßverfahren nach Anspruch 4 oder 5, **dadurch gekennzeichnet, daß** der durch Interpolation ermittelte hochauflösende inkrementale Positionsmeßwert (I1) in der zweiten Betriebsart einem Zähler (18) zugeführt wird, dessen Zählerstand nach der ersten Betriebsart auf die damit ermittelte grobauflösende Absolutposition (K) gesetzt wird.

7.  Positionsmeßverfahren nach einem der Ansprüche 4, 5 oder 6, **dadurch gekennzeichnet, daß** der durch Interpolation ermittelte hochauflösende inkrementale Positionsmeßwert (I1) in der zweiten Betriebsart einem Zähler (18) zugeführt wird, dessen Zählerstand bei insbesondere erstmaliger Abtastung einer Referenzmarke (R) auf eine bekannte, dieser Referenzmarke (R) zugeordneten absoluten Bezugsposition gesetzt wird.

8.  Positionsmeßverfahren nach Anspruch 4, **dadurch gekennzeichnet, daß** der Auswerteeinheit (2) in der ersten Betriebsart das Abtastsignal (A3, A4) der ersten Periode (P2) zugeführt und der Momentanwert (12) abgespeichert wird, daß nachfolgend in der ersten Betriebsart das Abtastsignal (A1, A2) der zweiten Periode (P1) zugeführt und der Momentanwert (I1) ebenfalls abgespeichert wird, und daß aus den abgespeicherten Momentanwerten (I1, I2) die momentane Phasendifferenz (ΔPhi) ermittelt wird.

**9.** Positionsmeßverfahren nach Anspruch 4, **dadurch gekennzeichnet, daß** in der ersten Betriebsart das Abtastsignal (A3, A4) der ersten Periode (P2) einer Interpolationseinrichtung (13) zur Ermittlung eines ersten Interpolationswertes (12) zugeführt wird, und danach das Abtastsignal (A1, A2) der zweiten Periode (P1) ebenfalls dieser gleichen Interpolationseinrichtung (13) zur Ermittlung eines zweiten Interpolationswertes (I1) zugeführt wird, und daß die grobauflösende Absolutposition (K) durch Vergleich zwischen dem ersten und zweiten Interpolationswert (I1, I2) ermittelt wird.

**10.** Positionsmeßverfahren nach Anspruch 9, **dadurch gekennzeichnet, daß** der Interpolationseinrichtung (13) in der zweiten Betriebsart kontinuierlich weiterhin das Abtastsignal (A1, A2) der zweiten Periode (P1) zugeführt wird und der Interpolationswert (I1) einem Zähler (18) zugeführt wird.

**11.** Positionsmeßverfahren nach Anspruch 7, **dadurch gekennzeichnet, daß** die Zählerstandsänderung zwischen der Abtastung zweier aufeinanderfolgender Referenzmarken (R) mit bekanntem Abstand mit einem vorgegebenen Wert verglichen wird und abhängig vom Vergleichsergebnis ein Fehlersignal erzeugt wird.

**Claims**

**1.** A position measuring system with a graduation carrier (5) which has a plurality of periodic graduation tracks (8, 9) of different graduation periods, a sensing unit (6) for generating analog sensing signals (A1 to A4) of first and second periods (P1, P2), wherein the periods (P1, P2) of the first and second sensing signals (A1 to A4) differ from one another only slightly, with a change-over switch apparatus (10, 16) which can be controlled in order

a) in a first mode of operation, to feed the sensing signals (A1 to A4) of both periods (P1, P2) simultaneously or sequentially to an evaluation unit (2), in order to form and output an absolute position (K) in a module (17) from the instantaneous values (I1,I2) of the sensing signals (A1 to A4) of both periods (P1, P2), and in order
b) in a second mode of operation, to feed at least a sensing signal (A1 to A4, D1 to D4) of one of the two periods (P1, P2) to the evaluation unit (2) in order to carry out an incremental position measurement from the instantaneous values (I1) of the sensing signals (A1 to A4, D1 to D4) of only one of the two periods (P1, P2) and to output a high-resolution measured position value.

**2.** A position measuring system according to claim 1, **characterized in that** at least one reference mark (R) with known absolute position is provided on the graduation carrier (5), and furthermore **in that** an interpolation device (13) is provided, in which one of the sensing signals (A1 to A4, D1 to D4) is present continuously in the second mode of operation and the interpolated value (I1) formed therein is fed to a counter (18), wherein a synchronization signal (RS) is present at the counter ( 18) during the sensing of the reference mark (R).

**3.** A position measuring system according to claim I or 2, **characterized in that** the graduation carrier is a graduated disc (5) of a rotary transducer (1) and **in that** the first graduation track (8) has N graduation periods (P1) and the second graduation track (9) has N - 1 graduation periods per revolution.

**4.** A position measuring method for determining the absolute position of a movable part (3), with a graduation carrier (5) which has a plurality of periodic graduation tracks (8, 9) with slightly different graduation periods (P1, P2), which are sampled by a sensing unit (6) to generate sensing signals (A1 to A4) with first and second periods (P1, P2), wherein in a first mode of operation the sensing signals (A 1 to A4) of the first period (P1) and the second period (P2) are fed to an evaluation unit (2) and a low-resolution absolute position (K) is determined and output from the phase difference (Δphi) of these sensing signals (A1 to A4) and, in a subsequent second mode of operation, one of the two sensing signals (A1, A2; A3, A4) of a first or second period (P1; P2) is subdivided in an interpolation device (13) for the incremental measurement of position and a high-resolution measured position value (I1) is output.

**5.** A position measuring method according to claim 4, **characterized in that** the low-resolution absolute position (K) determined in the first mode of operation is fed to a controller (7), which controls the startup of an electric motor (4) in dependence thereon.

**6.** A position measuring method according to Claim 4 or 5, **characterized in that** the high-resolution incremental measured position value (I1) determined by interpolation in the second mode of operation is fed to a counter (18) whose counting state is set according to the first mode of operation to the low-resolution absolute position (K) determined thereby.

**7.** A position measuring method according to any of claims 4, 5, and 6, **characterized in that** the high-resolution incremental measured position value (I1) determined by interpolation in the second mode of operation is fed to a counter (18) whose counting state is set to a known absolute reference position assigned to a reference mark (R), in particular on first time sensing of this reference mark (R).

**8.** A position measuring method according to claim 4, **characterized in that**, in the first mode of operation, the sensing signal (A3, A4) of the first period (P2) is fed to the evaluation unit (2) and the instantaneous value (I2) is stored, **in that** subsequently, in the first mode of operation, the sensing signal (A1, A2) of the second period (P1) is fed and the instantaneous value (I1) likewise stored, and **in that** the instantaneous phase difference (Δphi) is determined from the stored instantaneous values (I1, I2).

**9.** A position measuring method according to claim 4, **characterized in that** in the first mode of operation the sensing signal (A3, A4) the first period (P2) is fed to an interpolation device (13) for determining a first interpolated value (I2) and thereafter the sensing signal (A1, A2) the second period (P1) is likewise fed to this same interpolation device (13) for determining a second interpolated value (I1) and **in that** the low-resolution absolute position (K) is determined by comparison between the first and second interpolated values (I1, I2).

**10.** A position measuring method according to claim 9, **characterized in that**, in the second mode of operation, the sensing signal (A1, A2) of the second period (P1) is furthermore fed continuously to the interpolation device (13) and the interpolated value (I1) is fed to a counter (18).

**11.** A position measuring method according to claim 7, **characterized in that** the change in the counting state between the sensing of two reference marks (R) following one after the other with a known spacing is compared with a predetermined value and an error signal is generated, depending an the result of the comparison.

**Revendications**

**1.** Dispositif de mesure de position comprenant un support de division (5) qui présente plusieurs pistes de divisions (8, 9) périodiques, avec des périodes de division différentes, une unité de palpage (6) pour produire des signaux de palpage (A1 à A4) périodiques avec une première et une deuxième période (P1, P2), les périodes (P1, P2) des premiers et deuxièmes signaux de palpage (A1 à A4) n'étant que faiblement différentes l'une de l'autre, un dispositif de commutation (10, 16) commandable pour

- envoyer à une unité de traitement (2), dans un premier mode de fonctionnement, simultanément ou de manière séquentielle, les signaux de palpage (A1 à A4) des deux périodes (P1, P2) aux fins de former dans un module (17), à partir des valeurs momentanées (I1, I2) des signaux de palpage (A1 à A4) des deux périodes (P1, P2), une position absolue (K) et de la délivrer, et

- pour envoyer à l'unité de traitement (2), dans un deuxième mode de fonctionnement, au moins un signal de palpage (A1 à A4, D1 à D4) de l'une des deux périodes (P1, P2), aux fins de réaliser, à partir des valeurs momentanées (I1) des signaux de palpage (A1 à A4, D1 à D4) de seulement l'une des deux périodes (P1, P2), une mesure de position incrémentale et de délivrer une valeur de mesure de position avec une résolution élevée.

**2.** Dispositif de mesure de position selon la revendication 1, **caractérisé en ce qu'**il est prévu sur le support de division (5) au moins un repère de référence (R), avec une position absolue connue, et **en ce qu'**il est prévu en outre un dispositif d'interpolation (13), auquel, dans le deuxième mode de fonctionnement, l'un des signaux de palpage (A1 à A4, D1 à D4) est appliqué en continu et **en ce que** la valeur d'interpolation (I1) formée dans celui-ci est transmise à un compteur (18), un signal de synchronisation (RS) étant envoyé au compteur (18) lors du palpage du repère de référence (R).

**3.** Dispositif de mesure de position selon la revendication 1 ou 2, **caractérisé en ce que** le support de division est un disque gradué (5) d'un encodeur (1) et **en ce que** la première piste de divisions (8) présente N périodes de division (P1) et la deuxième piste de divisions (9) N-1 périodes de division par tour.

**4.** Procédé de mesure de position pour déterminer la position absolue d'un élément mobile (3), comportant un support de division (5) qui présente plusieurs pistes de divisions (8, 9) périodiques, avec des périodes de division différentes, qui sont palpées par une unité de palpage (6) pour produire des signaux de palpage (A1 à A4) périodiques d'une première et d'une deuxième période (P1, P2), dans un premier mode de fonctionnement, les signaux de palpage (A1 à A4) de la première période (P1) et de la deuxième période (P2) étant transmis à une unité de traitement (2) et une position absolue (K) avec une faible résolution étant déterminée sur la base de l'écart de phase (ΔPhi) desdits signaux de palpage (A1 à A4) et délivrée, et dans un deuxième mode de fonctionnement consécutif, l'un des deux signaux de palpage (A1, A2; A3, A4) de première ou de deuxième période (P1; P2) étant divisé dans une unité d'interpolation (13) à des fins de mesure de position incrémentale et une valeur de mesure de position (I1) avec une résolution élevée étant délivrée.

5. Procédé de mesure de position selon la revendication 4, **caractérisé en ce que** la position absolue (K) à résolution faible déterminée dans le premier mode de fonctionnement est transmise à une commande (7), qui, en fonction de celle-ci, commande un moteur électrique (4).

6. Procédé de mesure de position selon la revendication 4 ou 5, **caractérisé en ce que** la valeur de mesure de position (I1) incrémentale à résolution élevée déterminée par interpolation, dans le deuxième mode de fonctionnement, est transmise à un compteur (18) dont l'état, après le premier mode de fonctionnement, est amené à la position absolue (K) à faible résolution déterminée dans celui-ci.

7. Procédé de mesure de position selon une des revendications 4, 5 ou 6, **caractérisé en ce que** la valeur de mesure de position (I1) incrémentale à résolution élevée déterminée par interpolation, dans le deuxième mode de fonctionnement, est transmise à un compteur (18) dont l'état, notamment dans le cas d'un premier palpage d'un repère de référence (R), est amené à une position de référence absolue connue associée audit repère de référence (R).

8. Procédé de mesure de position selon la revendication 4, **caractérisé en ce que** dans le premier mode de fonctionnement, le signal de palpage (A3, A4) de la première période (P2) est transmis à l'unité de traitement (2) et la valeur momentanée (I2) est mémorisée, **en ce qu'**ensuite, dans le premier mode de fonctionnement, le signal de palpage (A1, A2) de la deuxième période (P1) est transmis à l'unité de traitement et la valeur momentanée (I1) est également mémorisée et **en ce que** l'écart de phase momentané ($\Delta$phi) est déterminé à partir des valeurs momentanées (I1, I2) mémorisées.

9. Procédé de mesure de position selon la revendication 4, **caractérisé en ce que** dans le premier mode de fonctionnement, le signal de palpage (A3, A4) de la première période (P2) est transmis à un dispositif d'interpolation (13) aux fins de déterminer une première valeur d'interpolation (I2), puis le signal de palpage (A1, A2) de la deuxième période (P1) est également transmis à ce même dispositif d'interpolation (13) aux fins de déterminer une deuxième valeur d'interpolation (I1), et **en ce que** la position absolue (K) à faible résolution est déterminée par comparaison entre les première et deuxième valeurs d'interpolation (I1, I2).

10. Procédé de mesure de position selon la revendication 9, **caractérisé en ce que** dans le deuxième mode de fonctionnement, le signal de palpage (A1, A2) de la deuxième période (P1) est transmis en continu au dispositif d'interpolation (13) et la valeur d'interpolation (I1) est transmise à un compteur (18).

11. Procédé de mesure de position selon la revendication 7, **caractérisé en ce que** la modification de l'état du compteur entre le palpage de deux repères de référence (R) consécutifs avec un espacement connu est comparée à une valeur prédéterminée et un signal d'erreur est émis en fonction du résultat de la comparaison.

Fig.1

Fig.2

Fig.3

Fig.4